# EUROPEAN PATENT APPLICATION

(11) **EP 1 263 050 A1**
(43) Date of publication of application: **04.12.2002**
(21) Application number: 01113178.6
(22) Date of filing: 30.05.2001
(51) Int. Cl.: H01L 27/105, H01L 21/8239, H01L 27/112, H01L 21/8246, H01L 21/768

(54) **Bitline contacts in a memory cell array**

(71) Applicant: Infineon Technologies AG, 81669 München (DE)
(72) Inventor: Schwalbe, Grit, 01097 Dresden (DE)
(74) Representative: Epping Hermann & Fischer

(57) **Abstract**

A memory cell array comprises a plurality of bitlines (2) arranged in a first direction on a substrate (1), a plurality of wordlines (4) arranged in a second direction perpendicular to said first direction above said bitlines (2) on said substrate (1), memory cells being disposed at the points at which said bitlines and wordlines cross each other, wherein said bitlines are covered by an isolating layer (3) and all the portions of the memory cell array between the bitlines, which are not covered by the wordlines, are covered by at least one isolating layer. The isolating layer (3) is removed from said bitlines by a step by which also the topmost of said at least one isolating layer is removed from the memory cell array at those portions which are not covered by said wordlines (4). An electrical conductive material (18) is provided on the exposed portions of said bitlines. The present invention can be applied to the manufacture of nitride read only memory cells. The electrical conductive material is prefereably provided by an inverse poly etch process, in which first a conductive material such as doped polysilicon is deposited on the whole chip area and then the conductive material is removed from the areas between the bitlines. The conductive material is etched in an etching step which also etches part of the substrate under the conductive material between the bitlines. Since in a subsequent step the area between the bitlines is filled with an isolating material, isolation trenches are formed in a self aligned manner.

## Description

The present invention relates to a method for providing bitline contacts in a memory cell array in which a plurality of bitlines is arranged in a first direction, a plurality of wordlines is arranged in a second direction perpendicular to said first direction above said bitlines, and memory cells are disposed at the points at which said bitlines and wordlines cross each other, wherein all the portions of the memory cell array which are not covered by the wordliens are covered by an isolating layer such as a silicon dioxide layer.

The present invention can very advantageously applied to NRQM™ (nitride read only memory) cells which are for example known from US-A-5,966,603, US-A-5,768,192, US-A-6,133,095, and US-A-5,963,465.

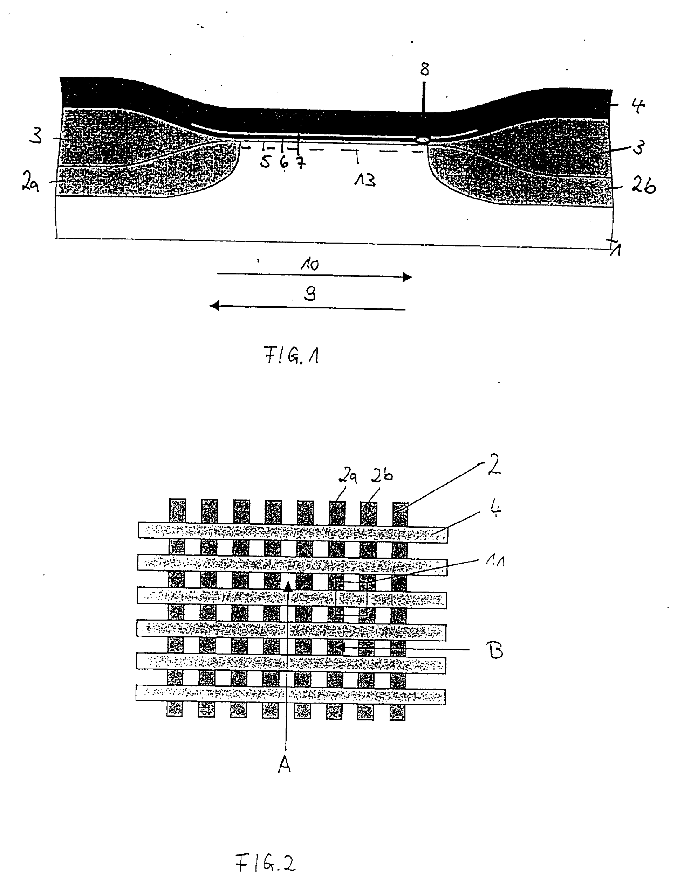

Such an NROM™ cell is a charge trapping memory device, which can be seen as a simple sub-micron MOS transistor whose gate oxide is replaced with a thin oxide-nitride-oxide (ONO) multi-layer stack, as can be seen from Figure 1. In Figure 1, reference numeral 1 denotes a substrate, for example of p-doped silicon. N⁺-doped bitlines 2 are arranged in a first direction, and they are covered by a thick silicon dioxide layer having a thickness of approximately 50 nm, also referred to as the bitline oxide 3. The word lines 4 made of polycide, a dual layer structure of tungsten silicide and polysilicon, are disposed in a second direction crossing the first direction. The second direction is prefereably perpendicular to the first direction. The ONO multi-layer comprising a silicon dioxide layer 5, a silicon nitride layer 6, and a silicon dioxide layer 7, is disposed between the wordline 4 and the silicon substrate 1. A transistor having a channel 13 is formed between two adjacent bitlines 2 acting as source and drain electrode, the wordline 4 acting as the gate electrode and the ONO multi-layer acting as the gate isolator. The ONO multi-layer covers the channel area 13 of the transistor.

The intermediate layer of the ONO multi-layer stack, i.e. the nitride layer 6, is the retaining material for one or two distinguishable pockets of electrons, close to the bitline 2 junction edge.

For sake of simplicity the concept of the NROM™ cell is described for the storage of one electron only. However, currently, the NROM™ cell is also applied for the storage of two electrons.

Figure 2 shows a top view of a two-dimensional array of NROM™ cells, made of a crisscross of n⁺-doped bitlines 2 and wordlines 4. The location of the trapped electron is near the bitline junction edge, as shown in Figure 1. Also shown is the memory cell 11 at the cross-section whose details are shown in Figure 1. The programming operation of the NROM™ cell is done by Channel Hot Electron injection, which stores a nominal less than a thousand electrons in a lumped pocket close to the drain side of the cell. These electrons are located in localized states in the nitride layer.

An electron 8, for example, is injected and trapped by applying a higher potential to the first bitline 2a than to the second bitline 2b, as is indicated by the programming direction 10. Additionally, a sufficient voltage is applied to the wordline 4. For reading the electron 8, a higher potential is applied to the second bitline 2b than to the first bitline 2a, as is indicated by the reading direction 9. Additionally, a low voltage is applied to the wordline 4.

As is obvious, the potential difference applied for reading is lower than the potential difference applied for programming. Since a comparatively high voltage is applied to the wordlines for programming, the thickness of the spacer which covers the wordlines must be thicker than in other known memory devices such as a DRAM (dynamic random access memory) in order to avoid a breakthrough between neighbouring wordlines or between a wordline and a bitline contact. In particular, typical voltages applied to the wordlines of NROM™ cells are approximately 12 Volts, whereas typical voltages applied to the wordlines of DRAM cells are 3 to 5 Volts.

Since the n⁺-doped bitlines 2 exhibit a considerable resistance, according to a standard cell architecture, metal lines are disposed on top of the memory cell array in arrays having a certain magnitude. These metal lines are also arranged in the first direction above the bitlines 2, and they are periodically connected to the underlying bitline via a contact. For example, every 8th or 16th memory cell has a contact to the metal line so as to reduce the bitline resistance. Since these metal lines usually are very thick, they place a further restriction upon the shrinkage of the memory cell size.

Conventionally, the contact between bitline and metal line can be provided by a method in which after the formation of the wordlines the whole memory cell array is covered by a boron phosphorous silicate glass as well as a silicon dioxide layer. Then, the silicon dioxide layer, the boron phosphorous silicate glass as well as the underlying bitline oxide are etched at predetermined positions which are for example photolithographically defined using a mask having a hole pattern so as to provide the contact holes. Thereafter, the contact holes are etched selectively with respect to the wordlines, especially the nitride spacer and nitride cap of the gate electrodes. Accordingly, the lateral extension of the contact holes is essentially defined by the spacing between neighbouring wordlines. For this reason, this contact is called a self aligned contact (SAC).

This process involves two major disadvantages. On one hand, as explained above, the voltages applied to the wordlines of NROM™ cells are much higher than those applied to the wordlines of other known memory cells such as DRAM (dynamic random access memory) cells. Therefore, the nitride spacer and the cap nitride have to withstand much higher voltages and, thus, are made thicker. Consequently, the space between neighbouring wordlines is reduced and the aspect ratio of the contact holes is much increased. In more detail, since the silicon dioxide layer usually has a thickness of 500 nm, contact holes having a very high aspect ratio of 10 to 15 have to be etched. Thus, it becomes very difficult to entirely etch the silicon dioxide layer, the phosphorous boron silicate glass as well as the underlying bitline oxide and, subsequently, fill the space between neighbouring wordlines.

On the other hand, the etching time has to be appropriately adjusted in order to avoid that the nitride spacer be etched too much. Accordingly, the process of etching the bitline oxide during the NROM™ fabrication is very critical. Unsufficient etching times will result in an unsufficient contact between bitline and bitline contact. However, for a better device performance, a low RC constant of the bitline contact is necessary in order to achieve a higher saturation current and a better signal detection. Moreover, excessive etching times will result in shorts between bitline contact and wordline which is a major problem in the fabrication of memory cell arrays.

By introducing a new etching gas, especially C₅F₈, having a higher selectivity of etching silicon dioxide deposited by the TEOS process with respect to silicon nitride, or by depositing a phosphorous boron silicon glass having a reduced thickness so that the stack which must be etched assumes a reduced height, the above problems can be partially solved. However, the results obtained still are not entirely satisfactory.

Another drawback arises since neighbouring bitlines are unsufficiently isolated from each other. Accordingly, there is a remarkable danger of punchthrough or leakage. However, the introduction of a conventional STI (shallow trench isolation) process into the hitherto known process of manufacturing an NROM™ cell array would lead to an increased cell size due to overlay requirements.

From T.H. Yoon et al., Symp. on VLSI Tech. Dig., 1999, p. 37, it is known to replace an SAC process by a so-called Pre Poly Plug process in which doped silicon is entirely deposited and patterned so as to provide a cell plug in a DRAM cell. However, as is obvious, a DRAM cell has a structure which is completely different from that of an NROM™ cell, and, in particular, there is no bitline oxide which has to be etched in order to provide a bitline contact.

It is an object of the present invention to provide an improved method for providing bitline contacts in a memory cell array such as an NROM™ chip. Moreover, it is an object of the present invention to provide an improved memory cell array as well as an improved NROM™ chip.

According to the present invention, the above object is achieved by a method for providing bitline contacts in a memory cell array comprising a plurality of bitlines arranged in a first direction on a substrate, a plurality of wordlines arranged in a second direction crossing said first direction above said bitlines on said substrate, memory cells being disposed where said bitlines and wordlines cross each other, wherein said bitlines are covered by an isolating layer and all the portions of the memory cell array between the bitlines, which are not covered by the wordlines, are covered by at least one isolating layer, said method comprising the steps of removing said isolating layer from said bitlines by a step by which also the topmost of said at least one isolating layer is removed from the memory cell array at those portions which are not covered by said wordlines, and providing an electrical conductive material on the exposed portions of said bitlines.

In addition, the present invention provides a method for providing bitline contacts in a nitride read only memory (NROM) chip, said memory chip comprising a memory cell array in which a plurality of memory cells are disposed in a substrate at the points where a plurality of bitlines arranged in a first direction and a plurality of wordlines arranged in a second direction crossing said first direction cross each other, wherein said bitlines are covered by an isolating layer and all the portions of said memory cell array between said bitlines, which are not covered by said wordlines, are covered by at least one isolating layer, each of said memory cells comprising a field effect transistor having an insulator covering its channel region wherein said insulator is an oxide-nitride-oxide multi-layer stack for storing one or more injected electrons, and a peripheral portion comprising logic components, said method comprising the steps as defined above.

Moreover, the present invention provides a memory cell array as well as a nitride read only memory (NROM™) chip having bitline contacts produced by the method as defined above, respectively.

More specifically, according to the present invention, the isolating layer is completely removed from the memory cell array at those portions which are not covered by the wordlines. This is in contrast to the known methods in which the isolating layer is only partially removed at those portions which are photolithographically defined by a hole mask.

As a consequence, photolithography is only necessary for masking the logic components in the peripheral portion of the memory chip, so that they are not etched. To this end, the mask for defining the memory cell array can be used for lithography. However, as is obvious, such a mask is much easier to handle and to adjust than a mask having a hole or a stripe pattern. Accordingly, the removal of the bitline oxid is no longer a critical step.

According to a preferred embodiment of the present invention, the step of removing the bitline oxid is performed time-controlled so that the underlying bitline is not attacked by this step.

Moreover, according to a preferred embodiment of the present invention, the electrical conductive material is provided on the exposed portions of the bitlines by an inverse poly etching process, in which, first, doped polysilicon is deposited over the whole cell array and, then, the doped polysilicon is removed from the areas between the bitlines. To this end, the doped polysilicon is advantageously covered by a photoresist material which is then patterned using a mask having a stripe pattern.

This inverse poly etching process is particularly advantageous since in contrast to known methods, in which contact holes are etched into an isolating material, the polysilicon is only removed at the areas between the bitlines. Therefore, according to this embodiment of the present invention, a self aligned contact etch is not performed, and the spacer and cap nitride on the gate electrodes are not attacked whereby shorts between bitlines and wordlines are avoided. In addition, the aspect ratio of the bitline contacts can be increased. As a consequence, the thickness of the spacers on the wordlines can be increased.

Furthermore, for removing the doped polysilicon, a mask having a stripe pattern is used. However, the alignment of such a mask is much easier than the alignment of a mask having a hole pattern. As a consequence, a misalignment of the mask can be largely avoided and an overlay mistake does not occur.

In particular, when the present invention is applied to a nitride read only memory cell array, the increased thickness of the spacer is highly advantagous since the gate electrodes in these cell arrays have to withstand much higher voltages than, for example, in DRAM cell arrays.

According to a preferred embodiment of the present invention, the step of etching the electrical conductive material in the exposed regions is performed as an over-etching step so that part of the substrate under the electrical conductive material is also removed. By a following step of filling an isolating material such as boron phosphorous silicate glass, neighbouring bitlines are electrically isolated from each other. Thus, a self-aligned shallow trench isolation (STI) is performed which is highly advantageous due to the smaller cell size required with respect of conventional STI procedures.

The memory cell array as well as the nitride read only memory cell array of the present invention are different from the known memory cell arrays and nitride read only memory cell arrays, respectively, since bitline oxide is completely removed from the bitlines at those portions which are not covered by the wordlines. In contrast, in the known memory cell arrays, the bitline oxide is removed at every 3rd or 4th memory cell, at those portions, at which by the conventional SAC process using a contact hole mask the contact holes are defined.

The memory cell array as well as the nitride read only memory cell array of the present invention are especially advantageous with respect to the known ones since they exhibit an improved resistance to shorts between wordlines and bitlines due to their increased spacer thickness.

The method for providing bitline contacts in a memory cell array can be applied to any cell type in which the bitline is covered by an isolating layer such as a bitline oxide. Typical cell types to which the present invention can be applied include ROM and EPROM cells.

In the following, the present invention will be described in more detail with reference to the accompanying drawings.

| | |
|---|---|
| Figure 1 | shows a cross-sectional view of an NROM™ memory cell; |
| Figure 2 | shows an examplary memory cell array to which the present invention can be applied; |
| Figures 3 | and 4A to 4C illustrate the steps for preparing an NROM™ memory cell array according to known methods; |
| Figures 5 to 9 | illustrate the steps of removing the bitline oxid in the method for providing a bitline contact according to the present invention; and |
| Figures 10 to 12 | illustrate the steps of providing an elec trical conductive material in the method for providing a bitline contact according to the present invention. |

The following description of the preferred embodiment of the present invention will mainly focus on the process of manufacturing an NROM™ memory cell array, in which essentially the steps of creating the memory cell components are described whereas the definition of the peripheral parts of the memory cell array comprising logic components is only schematically outlined. As is clearly to be understood, the peripheral parts of the memory cell array are manufactured by generally known methods.

First, isolation trenches 21 for a standard shallow trench isolation (STI) are etched in a substrate 1, for example of p-doped silicon, and, subsequently are filled with an isolating material such as silicon dioxide. These isolation trenches are provided at a distance corresponding to the distance of approximately 64 bitlines, which are to be defined later, and they are used for separating larger cell areas.

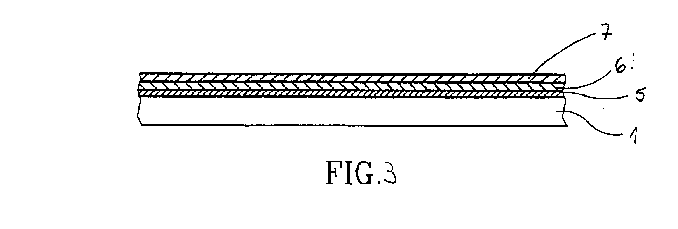

Then, an ONO multi-layer comprising a 5 nm to 15 nm SiO₂ layer 5, a 2 to 15 nm Si₃N₄ layer 6 and a 5 to 15 nm SiO₂ layer 7 is deposited by conventional processes on the semiconductor substrate 1 so that the entire substrate is covered with an ONO multi-layer as is shown in Figure 3.

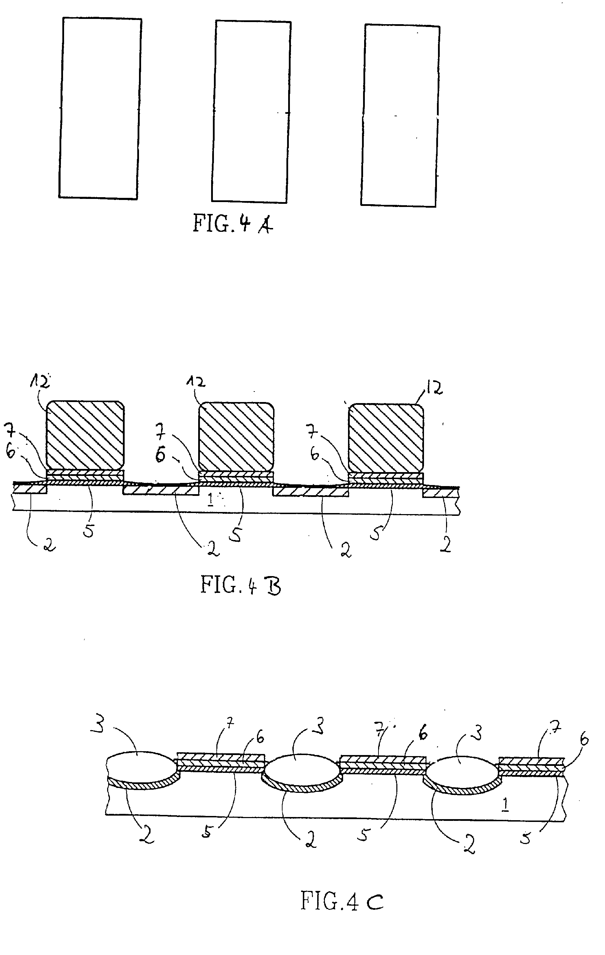

Thereafter, a bitline mask which is typically photoresist patterned in a well known manner is deposited on the substrate in order to create the bitlines, forming lines of source electrodes and lines of drain electrodes. The layout of the bitline mask within the memory cell array portion of the chip is shown in Figure 4A. As is shown in Figure 4B, the photoresist columns 12 define the areas where the bitlines 2 are not to be implanted. Accordingly, they are disposed at the channel regions 13 of the transistors as is shown in Figure 1. Figure 4C shows a cross section of the memory cell having the implanted bitlines.

Next, the top oxide 7 and the nitride layer 6 are etched from the regions between the photoresist columns 12, typically by a dry etching process. Thereafter, the bitlines 2 are implanted in the areas between the photoresist columns 12 with an n-dopant. By this process, the bitlines 2 are implanted in a self-aligned manner with respect to the photoresist columns 12.

Then, the photoresist columns 12 are removed, the ONO multi-layer is removed from the peripheral parts of the chip and a thermal oxidation process is perfomed. Thereby, bitline oxides 3 are thermally grown over the bitlines 2. Since the growth rate is much higher on the highly doped bitlines than on the nitride and oxide layers 6, 7, a thick layer of silicon dioxide is grown over the bitlines whereas a thin layer of silicon dioxide is grown along the sides of the nitride layer 6 and a thin layer of silicon dioxide is grown over the oxide layer 7. Moreover, a silicon dioxide layer acting as a gate isolating layer is grown in the peripheral portion of the chip.

A bitline oxide thickness of 20 to 70 nm is considered appropriate. Figure 4C shows a cross sectional view of the resulting structure.

Then, a polysilicon layer which will create wordlines of the memory cell array portion and will create gates for the peripheral transistors, is laid down over the chip. In the next step, a low resistive silicide, for example tungsten silicide, is deposited over the polysilicon layer so as to form a polycide layer having a reduced resistance. A typical total thickness of the polycide layer amounts to 100 to 200 nm. As shown in Figure 2 the polycide layer is then etched using a mask. Thereby, wordlines 4 are defined within the memory cell array, whereas gate electrodes are defined in the peripheral portion.

This etching step can be performed so that also at least the top oxide layer 7 and the nitride layer 6 are etched from between the word lines 4. As a result, only the bottom oxide layer 5 will remain in these areas, and it will be etched in the step of etching the bitline oxide to be performed later. This is especially useful if a self aligned shallow trench isolation is to be provided during the inverse poly etch process.

As an alternative, the step of etching the wordlines can also be performed so that the top oxide layer 7 and the nitride layer 6 are not attacked. In this case, the top oxide layer 7 will be etched in the step of etching the bitline oxide to be performed later, and the nitride layer 6 will act as an etch stop in the inverse poly etch process. Accordingly, with this wordline etching step, a self aligned shallow trench isolation, as will be explained later, will not be possible.

The resultant memory cell structure is shown in Figure 1.
The polycide layer 4 lies on top of the ONO multi-layers, thereby forming the gates of the NROM™ cells. The bitline oxides 3 are thick enough to isolate neighbouring ONO multi-layers.

Thereafter, a side wall oxidation step for the wordlines 4, a lightly doped drain (LDD) implant procedure into the CMOS periphery only and a spacer 15 deposition are performed. The LDD typically requires separate masks for the n-channel and p-channel peripheral transistors.

In NROM™ cells, the nitride spacer on the gate electrode should be thicker than the nitride spacer thickness of DRAM or embedded DRAM cells since they have to withstand a higher voltage due to the higher voltage applied to the gate electrodes. It is estimated that the spacer thickness should exceed 40 nm.

After forming this spacer, a nitride liner as well as a thick silicon dioxide spacer are deposited over the whole chip area. The thick silicon dioxide spacer which is formed by a chemical vapour deposition process using tetraethylorthosilicate (TEOS) is used for the transistors built in the peripheral portion. Thereafter, the thick silicon dioxide spacer is removed from the memory cell portion of the chip.

In the next step, the process of the present invention will be performed so as to define the bitline contacts for contacting the bitlines with metal lines which are to be formed later.

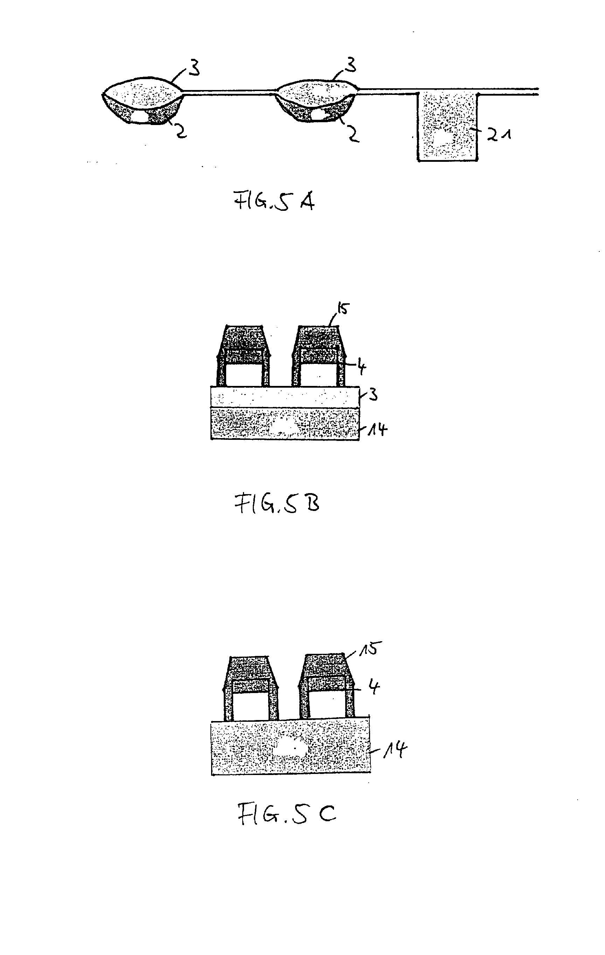

Figure 5A shows a cross sectional view of the memory cell array along direction A as defined in Figure 2, whereas Figure 5B shows a cross sectional view of the memory cell array along direction B as defined in Figure 2. Reference numeral 14 denotes the active areas of the memory cell array, and reference numeral 21 denotes an isolation trench filled with silicon dioxide which is used for separating larger cell areas. These isolation trenches 21 which are arranged every 64 bitlines were produced during the shallow trench isolation as explained above. Figure 5C shows a cross sectional view of the logic devices arranged in the peripheral part of the chip.

The nitride liner which was deposited after forming the nitride spacer may be partially removed at those locations at which the bitline oxide is to be etched.

First, a thin silicon dioxide layer 16 as well as a thin silicion nitride layer 22 are deposited over the whole chip. The thicknesses of both layers are selected so that they will not substantially be attacked during the following etching steps. As an alternative, the nitride liner is not removed and, in addition, a thin silicon nitride layer as well as a thin silicon dioxide layer are deposited.

Then, a photoresist material 17 (Figure 6C) is coated onto the whole chip and it is photolithographically patterned for masking the peripheral portion of the chip. As a result, the photoresist is removed from the whole memory cell array portion of the chip, whereas the photoresist material remains in the peripheral portion thereof.

As can be seen from Figure 6A which shows a cross sectional view of the memory cell array along direction A as defined in Figure 2 as well as from Figure 6B which shows a cross sectional view of the resultant memory cell array along direction B as defined in Figure 2, the photoresist material is completely removed from the memory cell array portion. As shown in Figure 6C which shows a cross sectional view of the logic devices arranged in the peripheral portion of the chip, the peripheral portion is completely protected by the photoresist material.

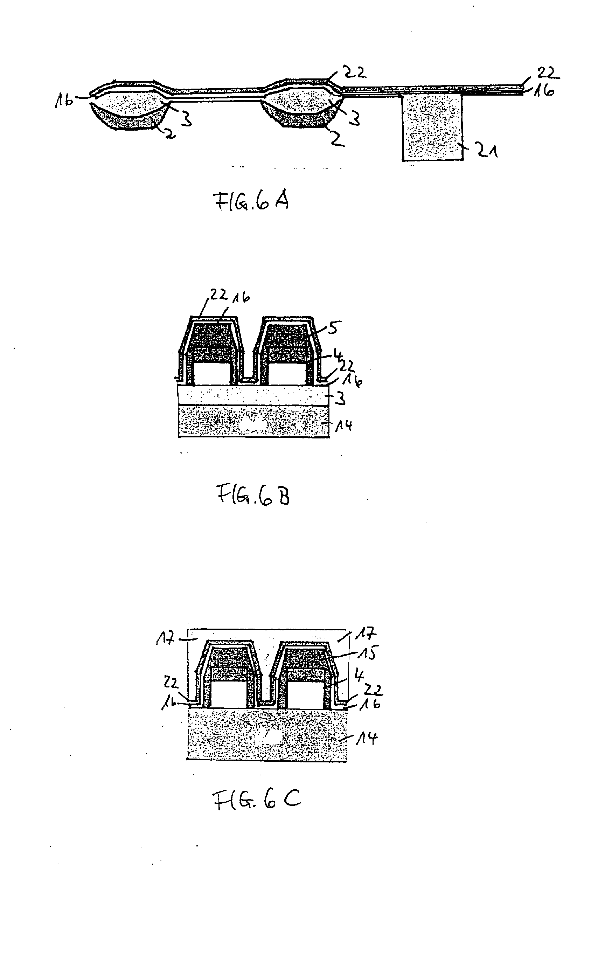

In a next step, the silicon nitride is etched selectively with respect to the underlying silicon dioxide layer (Figures 7A to 7C), and the photoresist material is removed from the whole surface. As a result, the peripheral portion is covered by a thin silicon nitride layer whereas the memory cell array is covered by the thin silicon dioxide layer, as can be seen from Figures 8A to 8C.

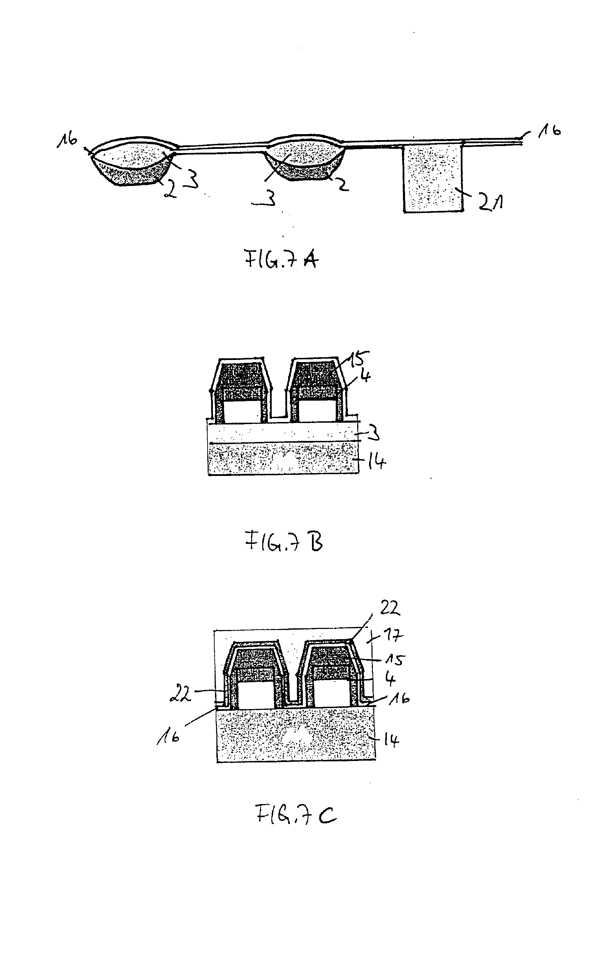

In the next step, the silicon dioxide is selectively etched with respect to silicon. In order to avoid that the nitride spacer of the gate electrodes will be attacked, it is important that the silicon dioxide is etched selectively with respect to silicon nitride, too. Since this etching process is time controlled, the silicon dioxide filled in the isolation trenches 21 will not be substantially attacked. Moreover, the bitlines formed of highly doped silicon will not be etched. Accordingly, the silicon dioxide is removed from the whole cell array, whereas the peripheral portion remains unaffected since it is protected by the silicon nitride layer 22, as can be seen from Figures 9A to 9C, wherein Figures 9A and 9B show a cross sectional view of the resultant memory cell array along direction A or B as defined in Figure 2, respectively, whereas Figure 9C shows a cross sectional view of the peripheral portion of the chip.

Since the bitline oxide is etched selectively with respect to silicon nitride and, in addition, the wordlines have been covered by an isolating layer such as made of silicon dioxide before depositing the photoresist material, the spacer on the wordlines is not attacked by this etching step.

This step of etching the silicon dioxide layer removes the silicon dioxide layer from the whole memory cell array. In detail the bitline oxide is etched from the bitlines at the portions which are not covered by the wordlines, and, in addition, a silicon dioxide layer is etched from the portions between the bitlines 2 which are not covered by the wordlines 4. In particular, if in the step of etching the wordlines, the ONO multi-layer stack has not been attacked, now the top oxide layer 7 is etched. On the other hand, if in the step of etching the wordlines the top oxide layer 7 and the nitride layer 6 have been etched, now the bottom oxide layer 5 is etched.

As a further modification of the described process steps, the spacer of the gate electrodes may as well be formed of silicon dioxide. Accordingly, the silicon nitride liner, which was deposited after the spacer formation, protects the underlying silicon dioxide spacer from etching. Since silicon dioxide has a higher resistance to breakthrough, the use of a silicon dioxide spacer is highly advantageous.

In the next steps, an electrical conductive material will be provided on the exposed portions of the bitlines. This can be done by a conventional process, which provides self-aligned contacts as was outlined above, or, according to a preferred embodiment of the present invention, by a so-called inverse poly etch as will be explained later.

For providing the electrical conductive material in the contact hole by a conventional process, first, a silicon oxynitride liner followed by a boron phosphorous silicate glass (BPSG) is deposited over the entire chip area. Thereafter, a silicon dioxide layer is deposited by a chemical vapour deposition process using TEOS (tetraethylorthosilicate). In this layer stack, the contact holes will be etched.

Then, a photoresist material is coated and the contact holes for contacting the bitlines are lithographically defined using a contact hole mask. The contact hole mask is designed so that every 3rd or 4th memory cell is connected with the metal lines which are to be formed later. After defining the contact holes in the photoresist layer, the silicon dioxide layer as well as the BPSG material are selectively etched, for example by dry etching with C₄F₈ or C₅F₈.

In a following step, the photoresist material is removed from the cell area and, optionally, an ion implantation step with arsenic ions is performed so as to reduce the contact resistance.

In the next step, an electrical conductive material such as n⁺-doped polysilicon is deposited so as to fill the contact holes. Then, the polysilicon on the chip surface is recessed, for example by wet etching or plasma etching using the BPSG layer as an etch stop layer. Thereafter, the metal lines will be formed in a manner that will be described later.

According to a preferred embodiment of the present invention, an electrical conductive material such as n⁺-doped polysilicon is provided by a so-called inverse poly etch process in which a doped polysilicon layer is deposited over the whole chip area, and this polysilicon layer is removed from those portions at which no contact is to be made.

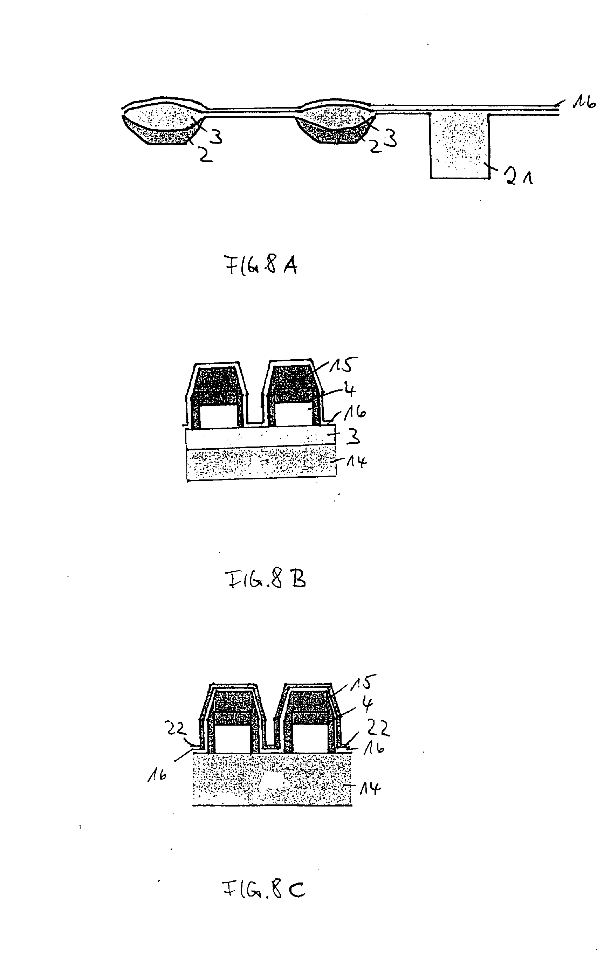

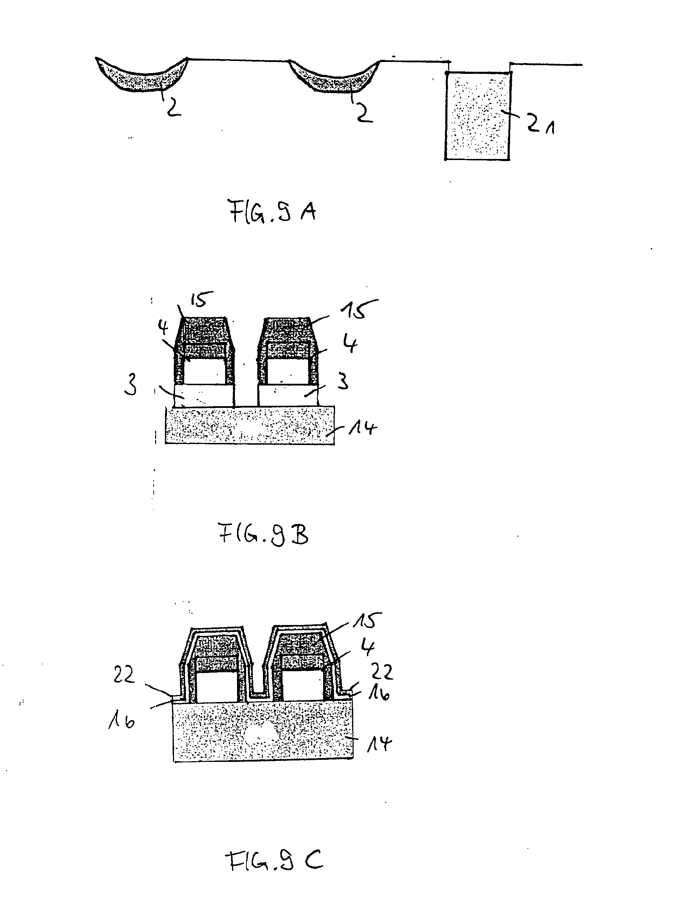

First, a wet cleaning process is performed in order to remove silicon dioxide residues as well as a native oxide from the silicon surface, so that the doped polysilicon layer will be directly deposited on the silicon surface. Thereafter, a highly n-doped polysilicon layer 18 is deposited so as to cover the whole chip area. Next, a chemical mechanical polishing step with a target of approximately 100 nm above the nitride cap of the wordline is performed. The resulting structure is shown in Figures 10A to 10C, wherein Figure 10A shows a cross sectional view of the memory cell array along direction A as defined in Figure 2, Figure 10B shows a cross sectional view of the memory cell array along direction B as defined in Figure 2, and Figure 10C shows a cross sectional view of the logic devices arranged in the peripheral portion of the chip.

Thereafter, a hardmask layer 19 of silicon nitride having a thickness of approximately 200 nm is deposited, and a photoresist material (not shown) is coated. Using a mask having a stripe pattern, for example a mask similar to that shown in Figure 4A, the photoresist material is patterned so that in the resulting photoresist pattern the areas between the bitlines 2 are exposed. The mask having a stripe pattern can for example be generated using the bitline mask.

Then, in the exposed areas between the bitlines 2, the hardmask layer 19 is removed and the n⁺-doped polysilicon 18 is removed by etching selectively with respect to silicon nitride. If during the step of patterning the wordlines 4 the top oxide layer 7 and the nitride layer 6 have not been removed from between the wordlines 4, this etching step will stop on the nitride layer 6.

According to an especially preferred embodiment of the present invention, the top oxide layer 7 and the nitride layer 6 have been removed from between the wordlines 4 during the step of patterning the wordlines 4, so that now no etch stop is present and the silicon substrate 1 is slightly etched in the cell area between the bit lines. The overetching is preferably performed time controlled so that a depth of the substrate larger than the implantation depth of the bitlines is etched.

Thereby, an isolation trench is formed in the memory cell array in a self aligned manner. Accordingly, by providing an isolating material in the isolation trench, neighbouring bitlines can be electrically isolated. Thus a self-aligned shallow trench isolation procedure can be performed which is advantageous with respect to the conventional shallow trench isolation procedure since in the procedure of the present invention there is no need of increasing the cell size in order to provide the isolation trenches.

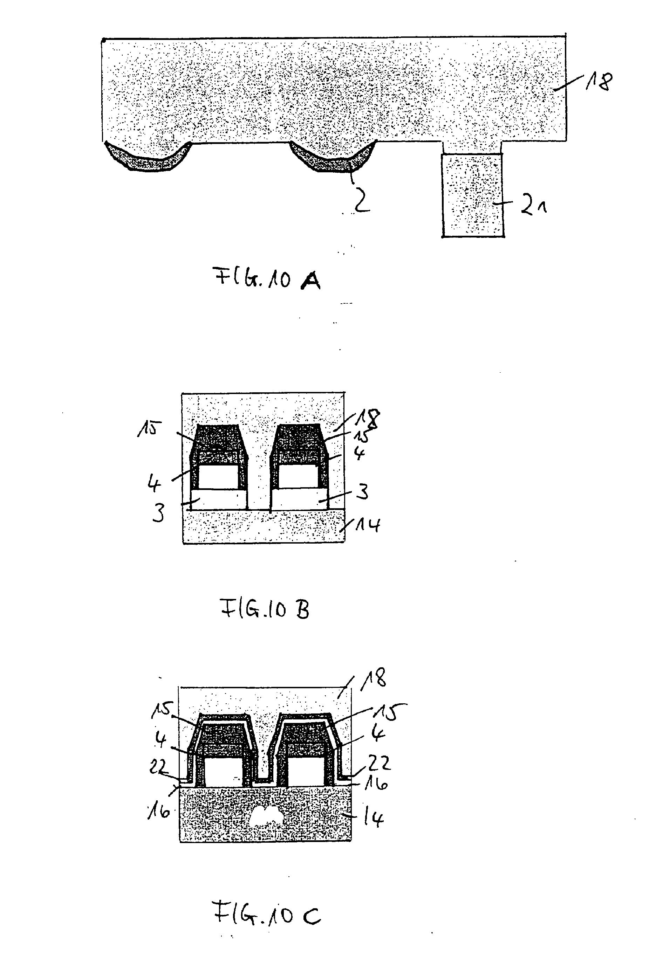

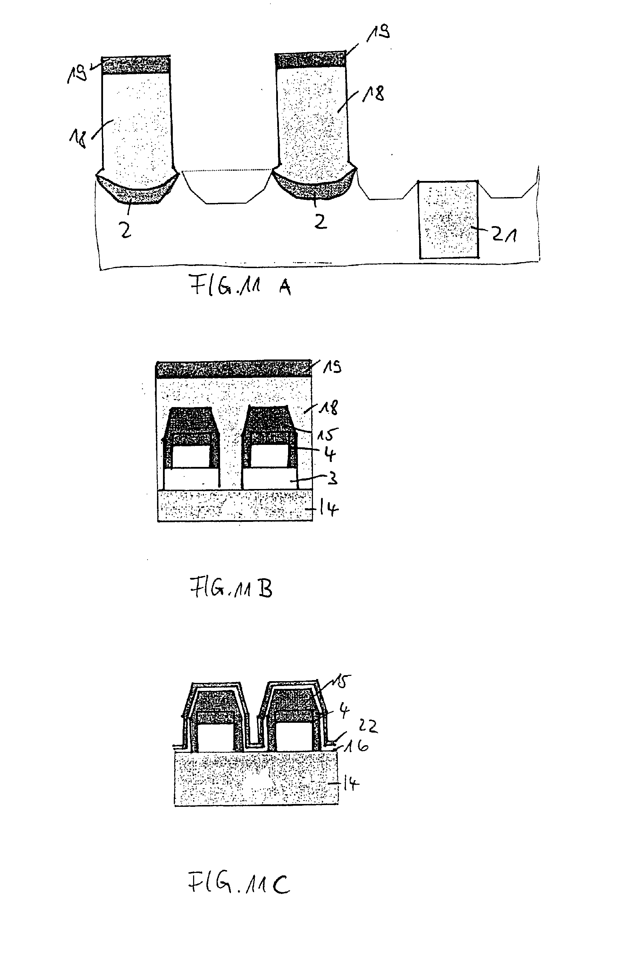

In a following step, the photoresist material will be removed. After removing the photoresist material, a structure as shown in Figures 11A to 11C is obtained, wherein Figure 11A shows a cross sectional view of the memory cell array along direction A as defined in Figure 2, Figure 11B shows a cross sectional view of the memory cell array along direction B as defined in Figure 2, and Figure 11C shows a cross sectional view of the logic devices arranged in the peripheral part of the chip. As can be clearly seen from Figures 11A and 11B, the polysilicon 18 remains only at those portions above the bitlines 2, whereas it is completely removed over the logic components in Figure 11C. Since a thin silicon dioxide layer 16 and a thin silicon nitride layer 22 were deposited before removing the bitline oxide, the peripheral portion is protected from etching.

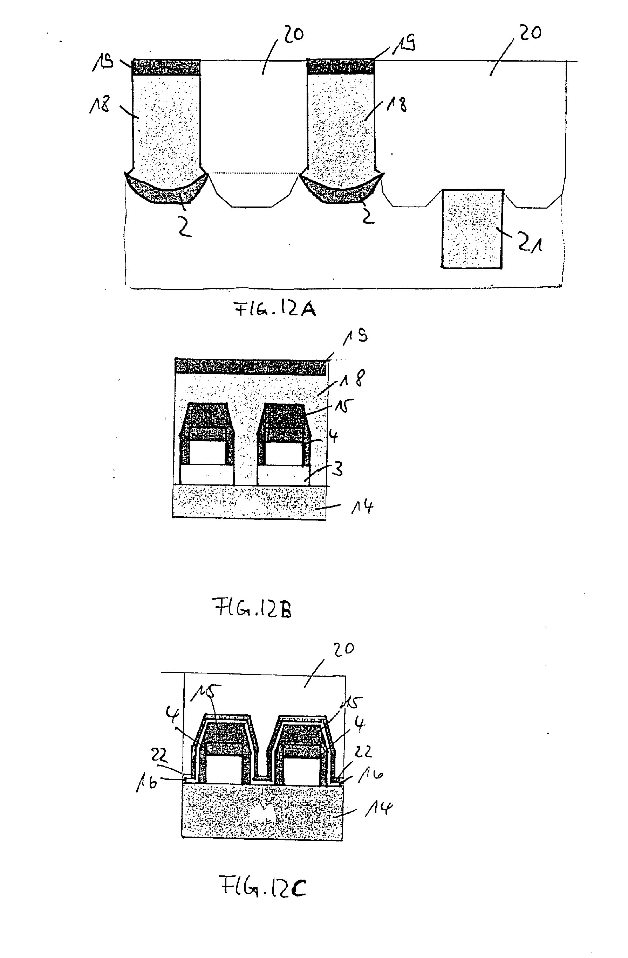

Thereafter, a boron phosphorous doped silicate glass (BPSG) layer 20 is deposited over the entire chip area and it is planarized using chemical mechanical polishing using the silicon nitride hardmask as a stop. The resultant structure is shown in Figures 12A to 12C, wherein Figure 12A shows a cross sectional view of the memory cell array along direction A as defined in Figure 2, Figure 12B shows a cross sectional view of the memory cell array along direction B as defined in Figure 2, and Figure 12C shows a cross sectional view of the logic devices arranged in the peripheral part of the chip.

Accordingly, the bitline contacts are completed by providing an electrical conductive material by a method in which, first, the material is deposited over the whole chip area and, then, it is removed from the areas at which a contact is not to be made. As a consequence, a self aligned etching step in which the wordlines act as an etching mask and, thus, could be attacked, does not occur. Since the etching step is not self aligned, the width between the word lines can be further reduced so that the thickness of the spacers on the gate electrodes can be increased. As a consequence, shorts between wordlines and bitline contacts can be largely avoided whereby the device performance is greatly improved.

The device performance can be remarkably improved if a self aligned shallow trench isolation is provided. As can be clearly seen from Figure 12A, isolation trenches filled with boron phosphorous glass are formed between the bitlines so as to provide an electrical isolation.

After removing the silicon nitride hardmask, the metal lines will be formed. The metal lines can be formed using the so-called damascene technique or any other arbitrary process. For creating the metal lines using the so-called damascene technique, first a silicon dioxide layer is deposited onto the entire chip area by a chemical vapour deposition process using tetraethylorthosilicate. Thereafter, trenches are etched into the silicon dioxide layer using a mask having a stripe pattern, for example the mask as used for defining the bitline contacts or a similar mask.

Then, a titanium liner and a layer of tungsten are deposited and the trenches are filled with these metals. Finally, the surface is planarized using chemical mechanical polishing or etching back of the metal so that the trenches are completely filled and no metal remains in the spaces between the trenches so that the trenches are electrically isolated from each other.

According to a different process, it is also possible to first deposite a titanium liner and the tungsten material, deposit a photoresist material, lithographically define the metal lines using a mask having a stripe pattern, for example the bitline mask, etch the metal layers and deposit silicon dioxide in order to electrically isolate the metal lines from each other.

Thereafter, the memory chip is completed in a conventional manner.

According to a further modification (not shown) of the present invention, on the structures as shown in Figures 5A to 5C, only a thin silicon dioxide layer 16 having an appropriate thickness as defined above is deposited, and the thin silicon nitride layer 22 is omitted.

In the next step, the peripheral portion of the chip is masked by a photoresist material, and the silicon dioxide is etched in the memory part of the chip. Then, the electrical conductive material is provided on the exposed portions of the bitlines. To this end, the conventional process for providing self aligned contacts as explained above can be performed. It is also possible to perform the inverse poly etching process as explained above. However, since in this case the peripheral portion of the chip is not protected by the silicon nitride layer 22, it is necessary that the doped polysilicon is etched selectively with respect to silicon dioxide in order to avoid that the logic components will be attacked. Thereafter, the memory chip will be completed in the manner as described above.

## Claims

1. A method for providing bitline contacts in a memory cell array comprising a plurality of bitlines (2) arranged in a first direction on a substrate (1), a plurality of wordlines (4) arranged in a second direction crossing said first direction above said bitlines (2) on said substrate (1), memory cells being disposed where said bitlines and wordlines cross each other, wherein said bitlines are covered by an isolating layer (3) and all the portions of the memory cell array between the bitlines, which are not covered by the wordlines, are covered by at least one isolating layer (5, 6, 7), said method comprising the steps of:
- removing said isolating layer (3) from said bitlines by a step by which also the topmost (5, 7) of said at least one isolating layer is removed from the memory cell array at those portions which are not covered by said wordlines (4); and
- providing an electrical conductive material (18) on the exposed portions of said bitlines.

2. The method for providing bitline contacts in a memory cell array according to claim 1, wherein the step of removing the isolating layer (3) from the bitlines (2) comprises the step of time-controlled etching the isolating layer (3) selectively with respect to the wordlines (4).

3. The method for providing bitline contacts in a memory cell array according to claim 1 or 2, wherein the step of providing an electrical conductive material (18) on the exposed portions of said bitlines comprises the steps of:
- depositing an isolating material onto the memory cell array;
- coating a photoresist material and lithographically defining contact holes in said photoresist material;
- etching said isolating material so as to create said contact holes; and
- depositing an electrical conductive material so as to fill said contact holes with said electrical conductive material.

4. The method for providing bitline contacts in a memory cell array according to claim 1 or 2, wherein the step of providing an electrical conductive material (18) on the exposed portions of said bitlines comprises the steps of:
- depositing said electrical conductive material (18) onto the memory cell array;
- removing said electrical conductive material (18) from the areas between the bitlines; and
- depositing an isolating material (20) in the areas between the bitlines.

5. The method for providing bitline contacts in a memory cell array according to claim 4, wherein the step of removing said electrical conductive material (18) from the areas between the bitlines (2) comprises the steps of:
- coating a photoresist material on said electrical conductive material and lithographically defining the regions where the electrical conductive material is to be removed using a mask having a stripe pattern; and
- etching the electrical conductive material (18) in the exposed regions.

6. The method for providing bitline contacts in a memory cell array according to claim 5, wherein by the step of removing said isolating layer (3) from said bitlines the substrate (1) is exposed at the portions between the bitlines which are not covered by the wordlines, and
the step of etching said electrical conductive material (18) is performed as an over-etching step so that part of the substrate (1) under the electrical conductive material is removed.

7. The method for providing bitlinecontacts in a memory cell array according to any of claims 2 to 6, wherein said isolating material (20) is a silicate glass doped with boron and/or phosphorous.

8. The method for providing bitline contacts in a memory cell array according to any of claims 1 to 7, wherein said electrical conductive material (18) is doped polysilicon.

9. A method for providing bitline contacts in a nitride read only memory chip, said memory chip comprising
- a memory cell array in which a plurality of memory cells are disposed in a substrate (1) at the points where a plurality of bitlines (2) arranged in a first direction and a plurality of wordlines (4) arranged in a second direction crossing said first direction cross each other, wherein said bitlines are covered by an isolating layer (3) and all the portions of said memory cell array between said bitlines (2), which are not covered by said wordlines (4), are covered by at least one isolating layer (5,6,7),
each of said memory cells comprising a field effect transistor having an isulator convering its channel region wherein said insulator is an oxide-nitride-oxide multi-layer stack for storing one or more injected electrons, and
- a peripheral portion comprising logic components,
said method comprising the steps as defined in any of claims 1 to 8.

10. A memory cell array having bitline contacts produced by the method of any of claims 1 to 8.

11. A nitride read only memory chip having bitline contacts produced by the method of claim 9.
